# EUROPEAN PATENT APPLICATION

(11) **EP 4 576 168 A1**
(43) Date of publication of application: **25.06.2025**
(21) Application number: 23219814.3
(22) Date of filing: 22.12.2023
(51) Int. Cl.: H01L 21/20

(54) **SUPPRESSION OF AUTO-DOPING DURING EPITAXIAL GROWTH OF EPITAXY LAYER IN A SEMICONDUCTOR DEVICE**

(71) Applicant: Nexperia B.V., 6534 AB Nijmegen (NL)
(72) Inventor: Böttcher, Tim, 22529 Hamburg (DE); Ley, Robin Laurent Karim, Hamburg (DE); Neges, Matthias Oliver, Hamburg (DE); Casimir Sergelius, Philip Peter, Hamburg (DE)
(74) Representative: Pjanovic, Ilija

(57) **Abstract**

A semiconductor device is proposed comprising one or more substrate layers, one or more epitaxy layers positioned above the one or more substrate layers, and a buffer layer directly in between the one or more substrate layers and the one or more epitaxy layers. The substrate layer may be a high doped Arsenic layer. The epitaxy layer may be low doped. The buffer layer may be a highly Phosphorous-doped Silicon layer. The buffer layer may be relatively thin, about 1 µm to 5µm. Moreover, a method of manufacturing such semiconductor device is proposed.

## Description

### Technical field

The present disclosure relates to a semiconductor device and a method of manufacturing such semiconductor device. More specifically, the present disclosure relates to the creation of low doping epitaxy layers above high doping substrate layers.

### Background

In the context of semiconductor technology, epitaxial layers play an important role in creating complex semiconductor devices. For instance, adding an epitaxial layer on a substrate can alter the material's properties and characteristics. These layers can be engineered with specific doping levels, thicknesses, and crystal structures to tailor the semiconductor's electrical, optical, or mechanical properties for various applications in electronics, optoelectronics, and photonics.

An epitaxial layer may be grown or deposited on a substrate using a process called epitaxy. Epitaxy involves the deposition of a crystalline layer on top of a crystalline substrate, where the deposited atoms align with the atoms of the substrate to create a single crystal structure.

An example of a semiconductor device is a diode device. Modern Silicon (Si) diode devices for electric cars and consumer devices frequently require high blocking voltages of, e.g., 400V, 650V and above. In order to achieve high breakthrough voltages, a high thickness of the epitaxial layer may be required, and at the same time, a very low dopant concentration. For example, a 400V diode may include a 6inch Arsenic (As) doped silicon substrate and an epitaxial layer having a dopant concentration of 0.08E15 1/cm³ and a thickness of 45µm. In another example, a 650V diode may include an 8inch Si:As substrate and an epitaxial layer having a dopant concentration of 0.15E15 1/cm³ and a thickness of 60µm.

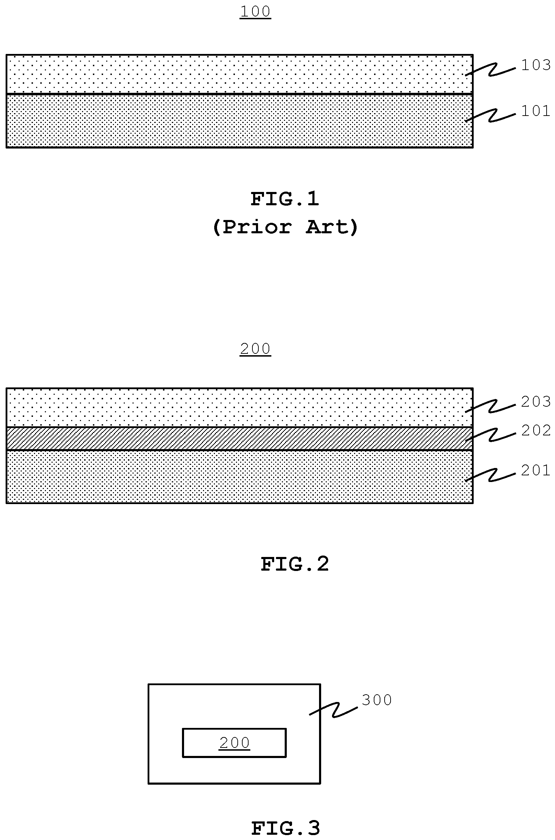

Fig. 1 shows a cross section of a part 100 of a semiconductor device including two layers of said semiconductor device. The semiconductor device typically includes further layers and/or structures not shown in Fig. 1. An example of a semiconductor device is the above-described Si diode device. The used substrate(s) 101 may have a high concentration of, e.g., As dopant ions, to reduce the resistivity as low as possible. On top of the substrate(s) 101, very low doped Si epitaxial layer(s) 103 may be deposited. As has a high vapor pressure, and during thermal treatments and epitaxial growth, the ions will out-diffuse from the substrate 101 and be re-deposited in the epitaxial layer(s) 103, especially on the wafer edge, disadvantageously leading to an increase in dopant concentration at this location accompanied by a reduction of breakthrough voltage with increased on-wafer inhomogeneity.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

The present disclosure aims to overcome the drawbacks identified in the background section. Advantageously, the solution of the present disclosure enables suppression of auto-doping, and in particular Arsenic (As) auto doping, during epitaxial growth of Silicon (Si) layers on blank substrates, in particular As-doped substrates.

According to an aspect of the present disclosure, a semiconductor device is presented. The semiconductor device may include one or more substrate layers. The semiconductor device may further include one or more epitaxy layers positioned above the one or more substrate layers. The semiconductor device may further include one or more buffer layers directly in between the one or more substrate layers and the one or more epitaxy layers.

In an embodiment, the one or more substrate layers may be high doped, e.g., above 1e15 1/cm³ or above 6e18 1/cm³. The one or more epitaxy layers may be low doped, e.g., below 1e15 1/cm³. The one or more buffer layers may be high doped.

In an embodiment, the one or more substrate layers may include an Arsenic doped Silicon substrate. The one or more epitaxy layers may include a Silicon epitaxial layer. The one or more buffer layers may include a Phosphorous doped Silicon layer.

In an embodiment, the one or more buffer layers may have a thickness of about 1µm to 5µm.

In an embodiment, the semiconductor device may be a Silicon based device.

In an embodiment, the semiconductor device may be a Silicon based power device.

In an embodiment, the semiconductor device may be one of a diode device, an insulated-gate bipolar transistor (IGBT), a bipolar transistor, a metal-oxide-semiconductor field-effect transistors (MOSFET), a rectifier, a Schottky diode.

According to an aspect of the present disclosure, a method of manufacturing a semiconductor device is proposed. The semiconductor device may have one or more of the above-described features. The method may include providing a substrate layer. The method may further include creating a buffer layer on top of the substrate layer. The method may further include creating an epitaxy layer on top of the buffer layer.

In an embodiment, the substrate layer may be high doped. The buffer layer may be high doped. The epitaxy layer may be low doped.

In an embodiment, the substrate layer may include an Arsenic doped Silicon substrate. The buffer layer may include a Phosphorous doped Silicon layer. The epitaxy layer may include a Silicon epitaxial layer.

In an embodiment, the buffer layer may have a thickness of about 1µm to 5µm.

In an embodiment, the creating of the buffer layer may include growing a highly Phosphorous-doped Silicon layer on the substrate layer at epi temperature. The creating of the epitaxy layer may include growing a low doped epi.

In an embodiment, the creating of the buffer layer and the creating of the epitaxy layer may be run in different reactors.

In an embodiment, the creating of the buffer layer and the creating of the epitaxy layer may be run in a same reactor.

### Brief description of the Drawings

Embodiments of the present disclosure will now be described, by way of example only, with reference to the accompanying schematic drawings in which corresponding reference symbol indicate corresponding parts, in which:
Fig. 1 shows a cross section of a part of a prior art semiconductor device;
Fig. 2 shows a cross section of a part of a semiconductor device, according to an aspect of the present disclosure;
Fig. 3 is an abstract representation of a semiconductor device, according to an aspect of the present disclosure;
Fig. 4 is a graph comparing profiles of epilayer with and without a Phosphorus-doped Silicon buffer; and
Fig. 5 show block diagrams of example fabrication processes for creating a buffer layer, according to an aspect of the present disclosure.

The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure may be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

Fig. 2 shows a cross section of a part 200 of a semiconductor device 300 (abstractly shown in Fig. 3), according to an aspect of the present disclosure. The part 200 may include three layers of said semiconductor device 300. The semiconductor device 300 typically includes further layers and/or structures not shown in Fig. 2. A non-limiting example of such semiconductor device 300 is an Si diode device for electric cars and consumer devices that require high blocking voltages of, e.g., 400V, 650V and above.

Instead of using a non/low-doped cap-layer directly on a substrate 101 followed by a low-doped epi 103, which is common in the industry, the present disclosure presents a buffer layer 202, preferably in the form of a high doped buffer layer 202 with Phosphorous (P) dopant ions, in between one or more substrates 201 (similar to substrate(s) 101) and one or more epitaxy layers 203 (similar to epitaxy layer(s) 103). Advantageously, a Phosphorous doped Si layer 202 is capable of almost completely suppressing As auto-doping from an As substrate 201.

Known cap layers disadvantageously typically add resistivity since they are intrinsic (very low/no intended doping). Advantageously, the high doped buffer layer 202 of the present disclosure does not add significant resistivity.

The buffer layer 202 is particularly effective when based on high Phosphorus doping. The diffusion of As and P happens through impurity-vacancy pairs, i.e. As₂-V and P-V pairs. In order to move, the dominant factor may be the movement of the vacancy in proximity to the impurity. For Phosphorus, the potential energy for vacancy movement is lower compared to the movement in proximity to Arsenic. This implies that for a Phosphorus-doped buffer 202, the vacancies will move with/to the Phosphorus impurities, and the Arsenic atoms are slowed down in diffusion. By contrast, in case of an undoped buffer, all the Si vacancies are available for the Arsenic atoms, and the diffusion is less suppressed.

In an example embodiment, the solution of the present disclosure may be used in Si power devices, such as above-described Si diode device. In an example embodiment, the solution of the present disclosure may be used in Si-based products using As doped substrates, which require a low doping of the epilayer, such as insulated-gate bipolar transistors (IGBTs), metal-oxide-semiconductor field-effect transistors (MOSFETs), rectifiers or Schottky diodes. In particular high voltage semiconductor devices benefit from the solution of the present disclosure.

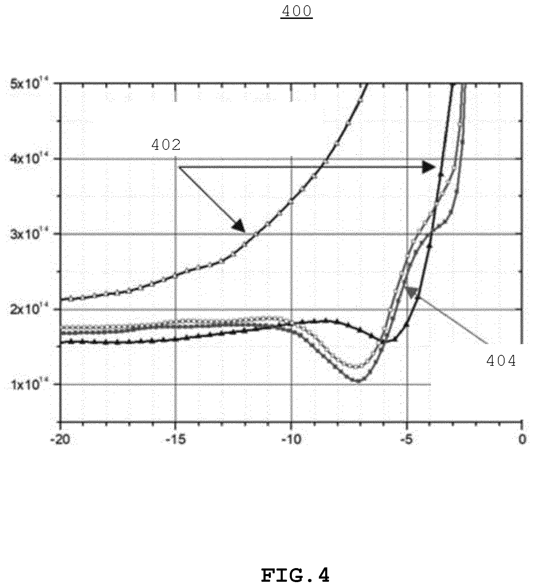

In contrast to an undoped buffer layer, the Phosphorus-doped buffer 202 may be relatively thin, e.g., having a thickness as low as about 1µm to 5µm, e.g., 2 µm. An example of the obtained doping profile in the center of the wafer and at the wafer edge is shown in the graph 400 of Fig. 4, where the profiles of epilayer with and without Phosphorus buffer 202 are compared. The two lines 402 depict a reference process without buffer layer 202. The two lines 404 depict a process including a buffer layer 202. The x-axis shows the distance from the substrate surface in µm (0@N=1e18cm⁻³) and includes the labels -20, -15, -10, -5 and 0. The y-axis shows the doping in cm⁻³ and includes the labels 1×10¹⁴, 2×10¹⁴, 3×10¹⁴, 4×10¹⁴ and 5×10¹⁴.

Lines 402 show a big difference between edge and center of the wafer. Lines 404 shows minimum to none difference between edge and center of the wafer. Whilst the epi without buffer layer (lines 402) shows a doping gradient of about 5-10µm at the wafer edge, the doping transition for the epi with buffer layer 202 (lines 404) drops down to about 1µm. This in turn results in a much narrower distribution of the product breakdown voltage, which may be intended to keep the wafer yield stable.

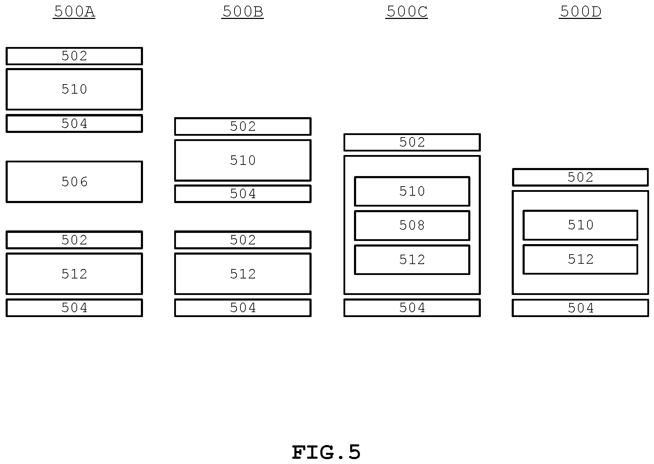

The epi buffer layer 202 may be deposited at the start of the epi growth process, after in-situ surface cleaning of the silicon wafer is completed. Fig. 5 shows four non-limiting block diagrams of example fabrication processes 500A-500D for creating the buffer layer 202. Depending on the actual tool situation, the fabrication process may be run in one or two reactor chambers, or even in two different reactors. All fabrication variations may lead to the same result, i.e., a sharp transition of the substrate-to-epi doping. Each fabrication process 500A-500D may have been preceded by the creation of a substrate layer 201, such as a high doping As substrate (not shown).

Example fabrication process 500A includes a wafer lock-in 502 followed by growing of the buffer layer 202 in step 510 run in a first epi reactor. Thus, a high doped buffer layer 202, e.g., a high doped Phosphorous doped Si layer, may be created on top of a substrate 201, such as a high Arsenic (As) doped Silicon substrate. Step 510 is followed by a wafer lock-out 504. Step 506 involves a wafer surface clean process. Next step 502 is a wafer lock-in, which is followed by growing of the epitaxy layer 203 in step 512 run in a second epi reactor. Thus, a low doped epitaxy layer 203 may be created on top of the buffer layer 202. Step 512 is followed by a wafer lock-out 504.

Example fabrication process 500B is similar to the fabrication process 500A but skipping the wafer surface cleaning step 506.

Example fabrication process 500C includes a wafer lock-in 502 followed by growing of the buffer layer 202 in step 510. Thus, a high doped buffer layer 202, e.g., a high doped Phosphorous doped Si layer, may be created on top of a substrate 201, such as a high Arsenic (As) doped Silicon substrate. Step 510 is followed by a purge process 508. Next, the epitaxy layer 203 is grown in step 512. Steps 510, 508 and 512 of process 500C are run in the same epi reactor. Step 512 is followed by a wafer lock-out 504.

Example fabrication process 500D is similar to the fabrication process 500C but skipping the purge step 508.

The process flow of the present disclosure, such as fabrication processes 500A-500D, enable suppressing of As out-diffusion during growth of high temperature epitaxial layers on highly doped wafers. The creation of the buffer layer 202 and the epitaxy layer 203 may start with epi with high Phosphorus-doped silicon layer 202, grown at epi temperature, then optionally purge, and continue with low doped epi for creating the epitaxy layer 203. As shown in the examples of Fig. 5, buffer layer epi may run on a different reactor separately from the low-doping growth reactor.

In the above examples, one buffer layer 202 is shown between the substrate layer(s) 201 and epitaxy layer(s) 203. The buffer layer 202 may include a plurality of buffer layers, e.g., implemented as a multi-buffer-layer structure, e.g., being low doped first, then high-doped.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

## Claims

1. A semiconductor device (300) comprising:
one or more substrate layers (201);
one or more epitaxy layers (203) positioned above the one or more substrate layers; and
a buffer layer (202) directly in between the one or more substrate layers and the one or more epitaxy layers.

2. The semiconductor device according to claim 1,
wherein the one or more substrate layers are high doped,
wherein the one or more epitaxy layers are low doped,
and wherein the buffer layer is high doped.

3. The semiconductor device according to claim 1,
wherein high doped is a doping above 1e15 1/cm³,
and wherein low doped is a doping below 1e15 1/cm³.

4. The semiconductor device according to any one of the preceding claims,
wherein the one or more substrate layers comprises an Arsenic doped Silicon substrate,
wherein the one or more epitaxy layers comprises a Silicon epitaxial layer,
and wherein the buffer layer comprises a Phosphorous doped Silicon layer.

5. The semiconductor device according to any one of the preceding claims,
wherein the buffer layer has a thickness of about 1µm to 5µm.

6. The semiconductor device according to any one of the preceding claims, wherein the semiconductor device is a Silicon based device.

7. The semiconductor device according to claim 6, wherein the semiconductor device is a Silicon based power device.

8. The semiconductor device according to claim 6 or claim 7, wherein the semiconductor device is one of:
a diode device;
an insulated-gate bipolar transistor, IGBT;
a bipolar transistor;
a metal-oxide-semiconductor field-effect transistors, MOSFET;
a PN rectifier;
a Schottky diode.

9. A method (500A-500D) of manufacturing a semiconductor device (300), providing a substrate layer (201);
creating (510) a buffer layer (202) on top of the substrate layer; and
creating (512) an epitaxy layer (203) on top of the buffer layer.

10. The method according to claim 9,
wherein the substrate layer is high doped,
wherein the buffer layer is high doped,
and wherein the epitaxy layer is low doped.

11. The method according to claims 9 or claim 10,
wherein the substrate layer comprises an Arsenic doped Silicon substrate, wherein the buffer layer comprises a Phosphorous doped Silicon layer,
and wherein the epitaxy layer comprises a Silicon epitaxial layer.

12. The method according to any one of the claims 9-11,
wherein the buffer layer has a thickness of about 1µm to 5µm.

13. The method according to any one of the claims 9-12,
wherein the creating of the buffer layer comprises growing a highly Phosphorous-doped Silicon layer on the substrate layer at epi temperature,
and wherein the creating of the epitaxy layer comprises growing a low doped epi.

14. The method according to any one of the claims 9-13,
wherein the creating of the buffer layer and the creating of the epitaxy layer are run in different reactors.

15. The method according to any one of the claims 9-14,
wherein the creating of the buffer layer and the creating of the epitaxy layer are run in a same reactor.
